## Europäisches Patentamt

## European Patent Office

## Office européen des brevets

(11) Publication number:

**0 068 679**
**B1**

# EUROPEAN PATENT SPECIFICATION

(45) Date of publication of patent specification: **11.11.87**

(51) Int. Cl.⁴: **H 01 L 21/76, H 01 L 21/31**

(21) Application number: **82302975.6**

(22) Date of filing: **09.06.82**

(54) **Method of manufacturing semiconductor devices comprising isolating regions.**

(30) Priority: **10.06.81 JP 88150/81**

(43) Date of publication of application:
**05.01.83 Bulletin 83/01**

(45) Publication of the grant of the patent:
**11.11.87 Bulletin 87/46**

(84) Designated Contracting States:
**DE FR GB NL**

(56) References cited:
**EP-A-0 009 677**
**US-A-4 026 736**

**EXTENDED ABSTRACTS OF THE JOURNAL OF THE ELECTROCHEMICAL SOCIETY, vol. 80-2, October 1980, Abstract no. 309, page 805, Princeton, New Jersey (USA); H.B.POGGE et al: "Planarization of large area deep groove isolation structures"**

**IBM TECHNICAL DISCLOSURE BULLETIN, vol. 22, no. 11, April 1980, pages 5148-5151, New York (USA); R.D.ISAAC: "Fabrication process for full ROX isolation without a bird's beak"**

(73) Proprietor: **Hitachi, Ltd.**
**5-1, Marunouchi 1-chome**
**Chiyoda-ku Tokyo 100 (JP)**

(72) Inventor: **Tamaki, Yoichi**
**1-217, Higashi-koigakubo**
**Kokubunji-shi Tokyo (JP)**
Inventor: **Kure, Tokuo**
**1-217, Higashi-koigakubo**
**Kokubunji-shi Tokyo (JP)**
Inventor: **Shiba, Takeo**
**3-1-3, Higashi-koigakubo**
**Kokubunji-shi Tokyo (JP)**
Inventor: **Higuchi, Hisayuki**
**4-24-4, Honcho Kokubunji-shi**
**Tokyo (JP)**

(74) Representative: **Paget, Hugh Charles Edward et al**
**MEWBURN ELLIS & CO. 2/3 Cursitor Street London EC4A 1BQ (GB)**

Courier Press, Leamington Spa, England.

## Description

The present invention relates to a method of manufacturing a semiconductor device. More particularly, it relates to a method of manufacturing a semiconductor device the respective elements of which are isolated by grooves.

- A semiconductor integrated circuit includes large numbers of active elements and passive elements such as transistors, diodes and resistors. Since these elements are all formed within one semiconductor substrate, they need to be electrically isolated from one another.

In order to achieve electrical isolation of the respective elements formed in the substrate, several methods have been proposed. Among them, a method called "pn-junction isolation" has heretofore been employed most extensively.

This method exploits the fact that a pn-junction exhibits a high resistance when reverse-biased. It consists in forming pn-junctions between the elements so as to isolate the respectively adjacent elements.

As stated above, pn-junction isolation has heretofore been the most common expedient for isolating the elements in semiconductor devices. Since, however, it involves such problems as requiring a large area and having large parasitic capacitances, it is difficult to use in a semiconductor device having high packaging density.

In order to solve such problems, a method called "groove isolation" has been proposed.

This method consists in forming grooves, for example, U-shaped or V-shaped in section, within the semiconductor substrate so as to isolate the respective elements by means of the grooves. It includes two cases: one case where the groove is entirely filled up with an insulator, and the other case where an insulating layer is formed on the side surface and bottom surface of the groove and where the remaining part is filled with polycrystalline silicon or the like. (Hereunder, isolation employing U-shaped or V-shaped grooves will be termed "U-groove or V-groove isolation" in this specification.)

As compared with the aforementioned pn-junction isolation, this groove isolation has various merits such as a small area requirement, small parasitic capacitances and a large isolation voltage. However, it involves the following problems, the solutions of which are eagerly desired.

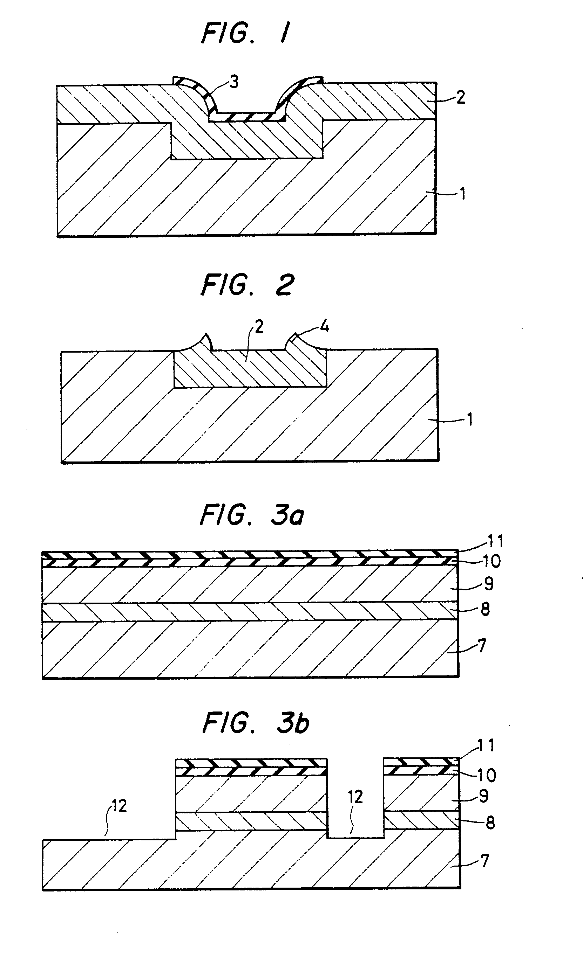

In U-groove isolation, it is common practice to adopt a method in which, as illustrated in Figure 1, a groove or recess is formed in a semiconductor substrate 1 in advance, a deposit material 2 such as an insulator or polycrystalline silicon is deposited on the whole surface of the substrate by a well known process such as CVD (chemical vapor deposition), a mask 3 covering the groove is formed and the film of the deposit material 2 is chemically etched. (When employing polycrystalline silicon as the filling material 2, as will be described later, the bottom surface and side surface of the groove are covered with a thin insulating film, whereupon the polycrystalline silicon is deposited to fill up the groove. In order to facilitate understanding, however, the formation of the thin insulating film is not explained here.)

When the filling material film 2 is etched in the above method, a bulge 4 of the filling material appears at an end part of the groove and results in an uneven upper surface above the groove as illustrated in Figure 2. Especially, when the mask 3 for the selective etching deviates from the pattern of the substrate, there is the disadvantage that the bulge 4 becomes still larger.

When a wiring run is formed on such a bulge, it is liable to disconnection due to the bulge. It is therefore difficult to form a semiconductor integrated circuit having high reliability.

In addition to the above description in relation to Figures 1 and 2, the following prior art will be briefly discussed.

1. Abstract No. 309 of the Journal of the Electrochemical Society, Vol. 80—2, October 1980, discloses planarization of large area deep groove isolation structures. In the disclosure, after the groove is filled with CVD—$SiO_2$, a photoresist is coated on the whole surface of the substrate to form a flat upper surface. Next, a reactive ion etching technique is applied to realize an isolation region having a flat surface.

2. I.B.M. Technical Disclosure Bulletin, Vol. 22, No. 11, April 1980, pages 5148—5151, discloses a fabrication process for full rox isolation without a bird's beak. In this disclosure the groove is filled up with a $SiO_2$ layer which is grown by selective oxidation of the semiconductor substrate.

3. US—A—4,026,736 discloses an integrated semiconductor structure with combined dielectric and PN junction isolation including fabrication method therefor. In this disclosure, a groove having a V-shaped sectional profile, is filled up with a $SiO_2$ layer and polycrystalline silicon. Surface planarity is realized by etching or using a mechanical lapping technique.

4. EP—A—0009677 discloses a residue-free and oxidation-resistant solution for etching thin silicon films. The chemical etchant contains ethylenediamine.

Accordingly, a method which can fill up the groove or recess provided in the semiconductor substrate and provide a flat upper surface is very desirable. Preferably such a method should be able to fill up a groove of any desired width and produce an upper surface having a good degree of flatness.

Briefly, the present invention employs a double-layer film made of different materials as an etching mask for a filling material contained in a groove, and it etches the filling material while side-etching the lower layer film, thereby to prevent a bulge from appearing.

According to the present invention there is provided a method of manufacturing a semiconductor device in which grooves are formed in the major surface of a semiconductor substrate, a filling material is deposited over the whole surface of the substrate including the inner surfaces of the grooves, a film is formed over the whole exposed surface of the filling material, and the filling material is etched in progressive stages using a mask and at least part of said film in at least two steps for flattening the device in order to remove all the filling material outside the grooves; characterized in that:

(a) said method is applicable to grooves the width of which is greater than the depth;

(b) two films are deposited one on top of the other over the whole exposed surface of the filling material, said films being formed of different materials;

(c) during the first stage of etching, the lower film over said grooves is side-etched by a greater amount than said upper film;

(d) during at least one subsequent step of etching the filling material, said lower film is used as the mask; and

(e) the steps of side etching the lower film and the filling material are repeated until all the filling material outside the wide grooves have been removed.

Preferred embodiments of the invention will now be described, with reference to the accompanying drawings, wherein:

Figures 1 and 2 are sectional views of a semiconductor substrate showing a prior-art method of forming an isolation groove;

Figures 3a to 3f are sectional diagrams showing the steps of a first method according to the present invention; and

Figures 4a to 4c are sectional diagrams for explaining problems of the prior art and a second method according to the present invention.

Embodiment 1

Figures 3a to 3f show the steps of manufacture in an embodiment of the present invention.

As shown in Figure 3a, a collector buried layer (0.5—1.5 μm thick) 8 was formed in the surface of a Si substrate 7 by a well known expedient such as ion implantation and thermal diffusion. A Si epitaxial layer (1—2 μm thick) 9 was formed on the layer 8 by the well known vapor epitaxial growth technique, whereupon its surface was thermally oxidized to form a $SiO_2$ film (100 nm thick) 10. Further, a $Si_3N_4$ film (100—300 nm thick) 11 was formed on the film 10 by the well known CVD process.

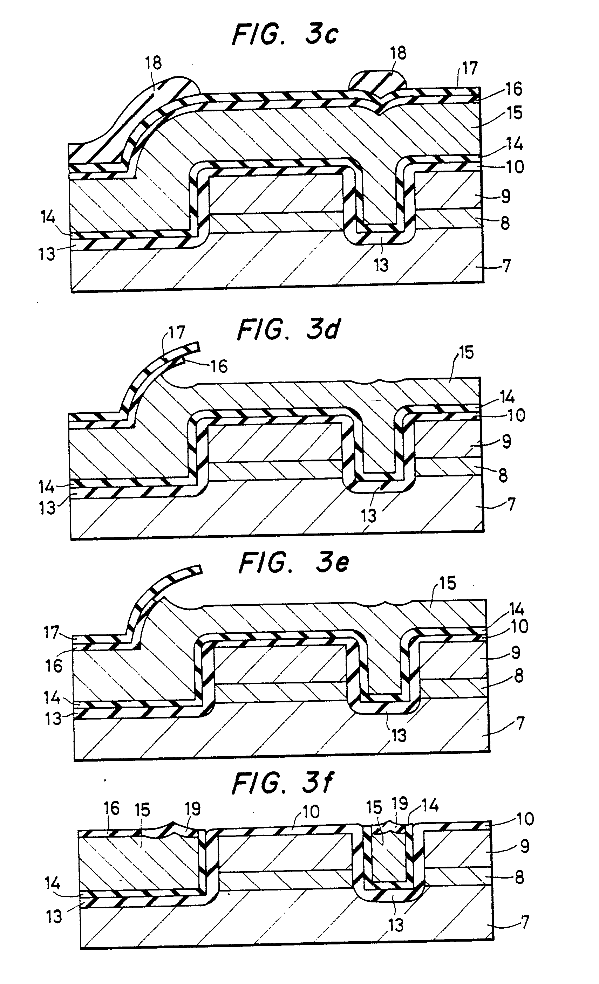

Subsequently, using the well known photo-etching technique, the $Si_3N_4$ film 11 was patterned to remove parts corresponding to grooves to be formed, and the exposed parts of the $SiO_2$ film 10 were etched and removed. Next, using a dry etching technique such as reactive sputter etching, Si was etched to form the deep grooves 12 (2—4 μm deep) which reached the substrate 7 by penetrating the Si epitaxial layer 9 as well as the collector buried layer 8 (Figure 3b). Under this state, an impurity of the conductivity type opposite to that of the buried layer 8 was introduced into the bottoms of the grooves 12 by ion implantation in order to prevent the occurrence of channels. As shown in Figure 3c, the surfaces of the grooves 12 were oxidized to form a $SiO_2$ film (200—600 nm thick) 13. After the remaining $Si_3N_4$ film 11 was etched and removed, a $Si_3N_4$ film (100—200 nm thick) 14 was formed on the whole surface of the resultant substrate again. Subsequently, polycrystalline Si 15 was deposited to a thickness approximately equal to the depth of the grooves 12 so as to fill up the grooves by the use of the conventional CVD process, its surface was oxidized to form a $SiO_2$ film (100—200 nm thick) 16, and a $Si_3N_4$ film (100—200 nm thick) 17 was formed thereon by the CVD process. Next, using conventional lithography, a photoresist pattern 18 having a device (for leaving parts corresponding to the grooves) converse to the device of the grooves was formed.

Next, the $Si_3N_4$ film 17 was etched by employing the photoresist pattern 18 as a mask, and after removing the photoresist 18, the exposed parts of the $SiO_2$ film 16 were etched by employing the remaining parts of the $Si_3N_4$ film 17 as a mask. The etching of the $SiO_2$ film 16 at this time was excessively performed to the extent that the parts of the $SiO_2$ film 16 underlying the remaining parts of the $Si_3N_4$ film 17 were side-etched or laterally etched about 1/5 of the depth of the grooves.

Subsequently, as shown in Figure 3d, the polycrystalline Si film 15 was etched down to a half of its thickness with an etchant such as hydrazine (KOH, NaOH, or a mixed solution consisting of fluoric acid and nitric acid may well be employed). Here, the $SiO_2$ film 16 was side-etched about 1/5 of the depth of the grooves again (Figure 3e).

The polycrystalline Si film 15 was etched again with the etchant such as hydrazine until the surface of the $Si_3N_4$ film 14 was exposed so that the polycrystalline silicon 15 might remain within the grooves only. After the $SiO_2$ film 16 underlying the pent roof of the $Si_3N_4$ film 17 was etched, an $SiO_2$ film (200—800 nm thick) 19 was formed in the surface of the polycrystalline Si 15 within each groove by thermal oxidation. The $Si_3N_4$ film 17 remaining on the surface of the resultant substrate was removed. The elements were thus isolated as shown in Figure 3f.

As seen from Figure 3f, a bipolar LSI thus manufactured has an improved surface flatness in comparison with an LSI manufactured by the prior-art method. Wiring formed on the upper surface is not liable to disconnection, and the yield of usable devices rises sharply.

Embodiment 2

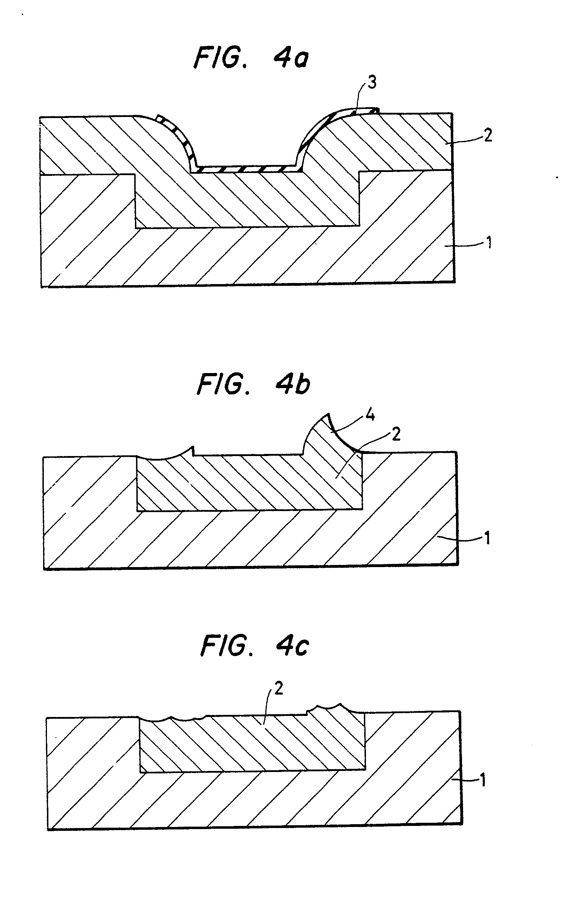

In embodiment 1, the etching of the polycrystalline Si 15 and the side etching of the $SiO_2$ film 16 used as the etching mask of the polycrystalline silicon 15 were alternately performed, such that each etching was executed twice. A further increase in the number of times of the etching operations brings forth the merits that the flatness of the surface can be enhanced and that any step which might appear is small even when the photoresist 18 has deviated on account of misregistration in the mask alignment, etc. This will now be described in detail. Where the etching mask 3 has deviated as illustrated in Figure 4a, the etching of the filling material 2 by the prior-art method poses the problem that a very large bulge 4 develops on one side of the groove as depicted in Figure 4b. In contrast, with the preferred method of the present invention, the bulge becomes very small and both the sides of the groove can finish up substantially flat as shown in Figure 4c. Here, Figure 4c illustrates the sectional shape of polycrystalline silicon obtained in a case where each of the etching of the polycrystalline silicon and the side etching of the $SiO_2$ film used as the mask was carried out three times. When the side etching operations are performed a larger number of times in this manner, the amount of the side etching and the amount by which the filling material is etched are made smaller in the later operations. Thus, the occurrence of the bulge is effectively prevented, and also the occurrence of a recess ascribable to the retreat of the mask is prevented. This measure is very effective for realizing the flattening of the surface.

In this embodiment, polycrystalline Si was used as the material for filling the groove. The filling material, however, is not restricted to polycrystalline silicon, but it is of course possible to employ an insulator such as $SiO_2$, $Si_3N_4$ and $Al_2O_3$ or an organic insulator such as "PIQ" (polyimide isoindoloquinazolinedione, registered trademark of Hitachi Chemical Co.). For example, when $SiO_2$ (non-doped, or P-doped, B-doped, Ge-doped or the like) is employed as the filling material 15, a double-layer mask for the etching of the filling material can be used which consists of a lower layer 16 made of polycrystalline Si and an upper layer 17 made of $Si_3N_4$, and the surface can be flattened by steps similar to those of the present embodiment. Needless to say, however, it is unnecessary to form the $SiO_2$ film 19 in this case.

This embodiment has been described as to the case where the present invention was used for the isolation of a bipolar IC. The present invention, however, is also applicable to various cases of flattening grooves or recesses, e.g. flattening the isolation regions or wiring conductors of a MOS—IC, and it is very useful.

Now, the applicability of the present invention will be supplementarily explained. As apparent from Figures 3c and 3d, in the case of a narrow groove, no large step appears on the surface even when the groove is filled up with the filling material 15. In this case, the processing with the prior-art method brings about no hindrance in practical use.

In contrast, in the case of a broad groove, a step approximately corresponding to the depth of the groove develops. Therefore, the occurrence of a large bulge is inevitable with the prior-art method, and the groove needs to be processed by the present invention.

When the groove has a width which is less than approximately double the depth thereof, it can be processed by the prior-art method.

However, if the groove is wider than approximately double the depth thereof, the present invention must be relied on.

For example, in the case of a bipolar integrated circuit of the present day, the depth of each groove for isolating elements is approximately 3 μm. Therefore, when the width of the groove is greater than approximately 5—6 μm, the upper surface of the groove needs to be flattened by the present invention. When the packaging density increases in the future, it is presumed that the depth of each groove for isolating elements will become approximately 2 μm or so. In this case, when the groove width is greater than approximately 4 μm, the present invention ought to be applied.

**Claims**

1. A method of manufacturing a semiconductor device in which grooves (12) are formed in the major surface of a semiconductor substrate, a filling material (15) is deposited over the whole surface of the substrate including the inner surfaces of the grooves, a film is formed over the whole exposed surface of the filling material, and the filling material is etched in progressive stages using a mask and at least part of said film in at least two steps for flattening the device in order to remove all the filling material outside the grooves; characterized in that:
   (a) said method is applicable to grooves (12) the width of which is greater than the depth;
   (b) two films (16, 17) are deposited one on top of the other over the whole exposed surface of the filling material, said films being formed of different materials;
   (c) during the first stage of etching, the lower film (16) over said grooves (12) is side-etched by a greater amount than said upper film (17);
   (d) during at least one subsequent step of etching the filling material, said lower film (16) is used as the mask; and
   (e) the steps of side etching the lower film (16) and the filling material (15) are repeated until all the filling material outside the wide grooves (12) has been removed.

2. A method of manufacturing a semiconductor device according to claim 1, wherein said filling material (15) is polycrystalline silicon.

3. A method of manufacturing a semiconductor device according to claim 2, wherein prior to the step of depositing the filling material, an insulating film (13) is formed on surfaces of said grooves (12).

4. A method of manufacturing a semiconductor device according to claim 3, wherein said insulating film is a double-layer film which consists of a silicon dioxide film (13) and a silicon nitride film (14).

5. A method of manufacturing a semiconductor device according to any one of claims 2 to 4, wherein the upper film (17) of said two films deposited over the exposed surface of the filling material is a silicon nitride film, while the lower film (16) is a silicon dioxide film.

6. A method of manufacturing a semiconductor device according to any one of claims 2 to 5, wherein said polycrystalline silicon (15) is etched with an etchant selected from hydrazine, potassium hydroxide, sodium hydroxide, or a mixed solution of fluoric acid and nitric acid.

7. A method of manufacturing a semiconductor device according to claim 1, wherein said filling material (15) is selected from silicon dioxide, silicon nitride, aluminium oxide, and polyimide isoindoloquinazolinedione.

**Patentansprüche**

1. Verfahren zum Herstellen einer Halbleitervorrichtung, bei dem Nuten (12) in der Hauptoberfläche eines Halbleitersubstrates gebildet werden, ein Füllmaterial (15) auf der gesamten Oberfläche des Substrates einschließlich der Innenflächen der Nuten abgeschieden wird, ein Film über der gesamten freiliegenden Oberfläche des Füllmaterials gebildet wird, und bei dem zum Abflachen der Vorrichtung für die Entfernung des gesamten Füllmaterials außerhalb der Nuten das Füllmaterial in fortlaufenden Stufen unter Verwendung einer Maske und wenigstens ein Teil des Filmes in wenigstens zwei Stufen geätzt werden, dadurch gekennzeichnet, daß

(a) das Verfahren auf Nuten (12) anwendbar ist, deren Breite größer ist als deren Tiefe;

(b) zwei Filme (16, 17) aufeinander über der gesamten freiliegenden Fläche des Füllmaterials abgeschieden werden, wobei diese Filme auf verschiedenen Materialien gebildet werden;

(c) während der ersten Stufe des Ätzens der untere Film (16) über den Nuten (12) in Seitenrichtung um einen größeren Betrag geätzt wird als der obere Film (17);

(d) während wenigstens einem nachfolgenden Ätzschritt des Füllmaterials der obere Film (16) als Maske verwendet wird, und

(e) die Schritte der seitlichen Ätzung des unteren Films (16) und des Füllmaterials (15) wiederholt werden, bis alles Füllmaterial außerhalb der breiten Nuten (12) entfernt ist.

2. Verfahren zur Herstellung einer Halbleitervorrichtung nach Anspruch 1, bei dem das Füllmaterial (15) polykristallines Silizium ist.

3. Verfahren zur Herstellung einer Halbleitervorrichtung nach Anspruch 2, bei dem vor dem Schritt zum Abscheiden des Füllmaterials ein Isolationsfilm (13) auf der Oberfläche der Nuten (12) ausgebildet wird.

4. Verfahren zur Herstellung einer Halbleitervorrichtung nach Anspruch 3, bei dem der Isolationsfilm ein Doppelschichtfilm ist, der aus einem Siliziumdioxidfilm (13) und einem Siliziumnitritfilm (14) besteht.

5. Verfahren zum Herstellen einer Halbleitervorrichtung nach einem der Ansprüche 2 bis 4, bei dem der obere Film (15) der beiden Filme, die auf der freiliegenden Oberfläche des Füllmaterials abgeschieden sind, ein Siliziumnitritfilm ist, während der untere Film (16) ein Siliziumdioxidfilm ist.

6. Verfahren zum Herstellen einer Halbleitervorrichtung nach einem der Ansprüche 2 bis 5, bei dem das polykristalline Silizium (15) mit einem Ätzmittel geätzt wird, das aus der Hydrazin, Kadiumhydroxid, Natriumhydroxid umfassenden Gruppe ausgewählt ist, oder mit einer Misch-lösung von Fluorwasserstoffsäure und Salpeter-säure geätzt wird.

7. Verfahren zum Herstellen einer Halbleitervorrichtung nach Anspruch 1, bei dem das Füllmaterial (15) Siliziumdioxid, Siliziumnitrit, Aluminiumoxid oder Polyimidisoindoloquinazolindion ist.

**Revendications**

1. Procédé de fabrication d'un dispositif à semiconducteurs, dans lequel on forme des rainures (12) dans la surface principale d'un substrat semiconducteur, on dépose un matériau de rempli-sage (15) sur l'ensemble de la surface du substrat, y compris les surfaces intérieures des rainures, on forme une pellicule sur l'ensemble de la surface à nu du matériau de remplissage, et on corrode le matériau de remplissage selon des étapes progressives en utilisant un masque et au moins une partie de ladite pellicule, selon au moins deux étapes, pour aplatir le dispositif de manière à éliminer l'ensemble du matériau de remplissage à l'extérieur des rainures; caractérisé en ce que

(a) ledit procédé est applicable à des rainures (12), dont la largeur est supérieure à la profondeur;

(b) on dépose deux pellicules (16, 17) l'une à la partie supérieure de l'autre, sur l'ensemble de la surface à nu du matériau de remplissage, lesdites pellicules étant constituées de matériaux différents;

(c) au cours de la première étape de corrosion, la pellicule inférieure (16) située au-dessus desdites rainures (12) est corrodée latéralement sur une épaisseur plus importante que ladite pellicule supérieure (17);

(d) pendant au moins une étape ultérieure de corrosion du matériau de remplissage, ladite pellicule inférieure (16) est utilisée en tant que masque; et

(e) on répète les étapes de la corrosion latérale de la pellicule inférieure (16) et du matériau de remplissage (15) jusqu'à ce que l'ensemble du matériau de remplissage situé à l'extérieur des rainures larges (12) ait été éliminé.

2. Procédé de fabrication d'un dispositif à semiconducteurs selon la revendication 1, pour lequel ledit matériau de remplissage (15) est du silicium polycristallin.

3. Procédé de fabrication d'un dispositif à semiconducteurs selon la revendication 2, selon lequel, avant l'étape de dépôt du matériau de remplissage, on forme une pellicule isolante (13) sur les surfaces desdites rainures (12).

4. Procédé de fabrication d'un dispositif à semiconducteurs selon la revendication 3, selon lequel ladite pellicule isolante est une pellicule à deux couches, qui comprend une pellicule de bioxyde de silicium (13) et une pellicule de nitrure de silicium (14).

5. Procédé de fabrication d'un dispositif à semiconducteurs selon l'une quelconque des revendications 2 à 4, selon lequel la pellicule supérieure (17) faisant partie desdites deux pellicules déposées sur la surface à nu du matériau de remplissage est une pellicule de nitrure de silicium, tandis que la pellicule inférieure (16) est une pellicule de bioxyde de silicium.

6. Procédé de fabrication d'un dispositif à semiconducteurs selon l'une quelconque des revendications 2 à 5, selon lequel ledit silicium polycristallin (15) est corrodé avec un agent corrosif choisi parmi l'hydrazine, l'hydroxyde de potassium, l'hydroxyde de sodium ou une solution mixte d'acide fluorhydrique et d'acide nitrique.

7. Procédé de fabrication d'un dispositif à semiconducteurs selon la revendication 1, selon lequel on choisit ledit matériau de remplissage (15) parmi le bioxyde de silicium, le nitrure de silicium, l'oxyde d'aluminium et l'isoindolo-quinazolinédione de polyimide.

FIG. 1

FIG. 2

FIG. 3a

FIG. 3b

0 068 679

## FIG. 3c

## FIG. 3d

## FIG. 3e

## FIG. 3f

2

## FIG. 4a

## FIG. 4b

## FIG. 4c